# EUROPEAN PATENT SPECIFICATION

(11) **EP 1 048 076 B1**
(45) Date of publication and mention of the grant of the patent: **17.01.2007**
(21) Application number: 99942923.6
(22) Date of filing: 26.08.1999
(51) Int. Cl.: H01L 27/02, H01L 29/74, H01L 29/87, H01L 29/749

(54) **LOW TRIGGER AND HOLDING VOLTAGE SCR DEVICE FOR ESD PROTECTION**
SCR BAUTEIL MIT NIEDRIGER SCHWELL- UND HALTESPANNUNG FÜR ESD SCHUTZ
REDRESSEUR A THYRISTORS A TENSION DE MAINTIEN ET DE DECLENCHEMENT FAIBLE POUR LA PROTECTION CONTRE LES DECHARGES ELECTROSTATIQUES

(30) Priority: 03.09.1998 EP 98202948
(43) Date of publication of application: 02.11.2000
(73) Proprietor: Koninklijke Philips Electronics N.V., 5621 BA Eindhoven (NL)
(72) Inventor: SCHROEDER, Hans, U., NL-5656 AA Eindhoven (NL); GRADENWITZ, Paul, G., M., NL-5656 AA Eindhoven (NL)
(74) Representative: White, Andrew Gordon
(86) International application number: PCT/EP1999/006275
(87) International publication number: WO 2000/014803

(56) References cited:
- EP-A- 0 703 622
- US-A- 4 896 243
- US-A- 5 455 436
- US-A- 5 572 394
- US-A- 5 682 047
- AMITAVA CHATTERJEE ET AL: "A LOW-VOLTAGE TRIGGERING SCR FOR ON-CHIP ESD PROTECTION AT OUTPUT AND INPUT PADS" IEEE ELECTRON DEVICE LETTERS,US,IEEE INC. NEW YORK, vol. 12, no. 1, page 21-22 XP000162296 ISSN: 0741-3106 cited in the application

## Description

The invention relates to a semiconductor device having a semiconductor body which on a surface comprises an integrated circuit containing protection means for protection against electrostatic discharge (ESD), the means being a compound element of an SCR and a gated diode, the protection means being provided in a surface area of a first conductivity type having a well of a second, opposite, conductivity type in which area a surface zone of the first conductivity type is formed forming one of the anode and cathode zones of the SCR element, and the surface area having a surface zone of the second conductivity type, further denoted as first zone, situated remote from the well and forming the other anode and cathode area of the SCR element, the gated diode containing a gate insulated from the surface of the semiconductor body and a highly-doped second conductivity type surface zone aligned to this gate further denoted as second zone, which aligned surface zone partly overlaps the well of the second conductivity type. Such a device is known, for example, from the article "A Low-Voltage Triggering SCR for On-Chip ESD Protection at Output and Input Pads" by A. Chatterjee et al., published in IEEE Electron Device Letters, vol. 12, no. 1, January 1991, pp. 21 and 22.

An SCR element (Silicon-Controlled Rectifier) is a four-layer npnp structure with connections on the outer n-layer and p-layer. As is known, the resistance of such an element in the one state is very high, so that no or substantially no current flows through the element; in the other state the resistance is very low, so that the element may carry a large current. The element changes from the one, non-conductive, state to the other state where the voltage between the connections reaches a certain value, the so-called trigger voltage. Beyond this point of the I-V characteristic, the voltage between the connections drops to a low value, the so-called holding voltage, and the I-V curve becomes very steep. When utilizing an SCR element as a protection of a CMOS circuit or a BICMOS circuit against ESD damage, it is important for the trigger voltage to be lower than the lowest voltage on the I/O pads at which damage may occur in the circuit. Generally, the trigger voltage is determined by the breakdown voltage of a pn-transition. In a standard CMOS process, the breakdown voltage of the pn-junction lies between the n well and the p-type surface area in the neighborhood of 40 V, which is much too high for ESD protection. The breakdown voltage of the pn-junction of the source/drain zone of the n-channel MOS transistors is about 10 V. By providing a gated diode along the edge of the well, for example, in the form of a MOS transistor, a trigger voltage of the desired value may be obtained. The transistor source or drain zone overlapping the well forms a gated diode triggering the SCR element, the other zone of the transistor forming the cathode of the SCR element in the known device.

The holding voltage should generally be larger than the supply voltage. In order to keep the dissipation in the protection lowest possible, a low holding voltage is desired. In practice it has turned out that in most standard processes the holding voltage lies above 6 V. However, often a lower holding voltage is desired, more particularly in low-power applications where the supply voltage is 3.3 V or less.

US-5,455,436 discloses a protection circuit against ESD comprising an NMOS transistor and an SCR element. A p-substrate has an n-well with a p+ surface zone for connection to an input/output pad. An n+ surface zone overlaps the n-well and forms the collector of the NMOS transistor. A further n-well is provided to provide a cathode for the SCR element.

It is an object of the invention to provide an ESD protection which has not only a low trigger voltage but also a low holding voltage. In addition, the invention is based, for example, on the recognition that in the known device the transistor zone overlapping the well shields the anode from load carriers which are injected by the cathode. The invention is further based on the recognition that the holding voltage, which generally increases when the distance between anode and cathode increases, is adversely affected by the presence of the transistor between anode and cathode.

According to the invention there is provided a semiconductor device defined by Claim 1. This configuration achieves that the anode and the cathode, in effect, are not shielded from each other by the gated diode, so that the load carriers injected by the cathode can reach the anode more easily, which results in a considerably lower holding voltage than in known devices.

According to the invention the gate of the gated diode substantially stretches out only along that part of the periphery of the well along which also the said second zone of the second conductivity type stretches out. This is advantageous, for example, in that the leakage current is relatively small as a result of the limited gate length. The invention is characterized in that the said first zone of the second conductivity type is situated at a shorter lateral distance from the surface zone of the first conductivity type provided in the well than the said further surface zone. In practice it turns out that the holding voltage more or less linearly changes with the distance from anode to cathode. The option is used of making this distance very small in a device according to the invention, that is, essentially smaller than the distance between the anode and the source of the transistor.

These and other aspects of the invention will be apparent from and elucidated with reference to the embodiments described hereinafter.

In the drawings:
Fig. 1 shows a part of an integrated circuit having an input protection against electrostatic discharge;
Fig. 2 shows a cross-section of an ESD protection according to the invention;
Fig. 3 shows a current/voltage characteristic of the ESD protection of Fig. 2;
Fig. 4 shows the layout of a second embodiment of an ESD protection according to the invention;
Fig. 5 shows a cross-section of this second embodiment along the line V-V; and
Fig. 6 shows a cross-section of this embodiment along the line VI-VI in Fig. 4.

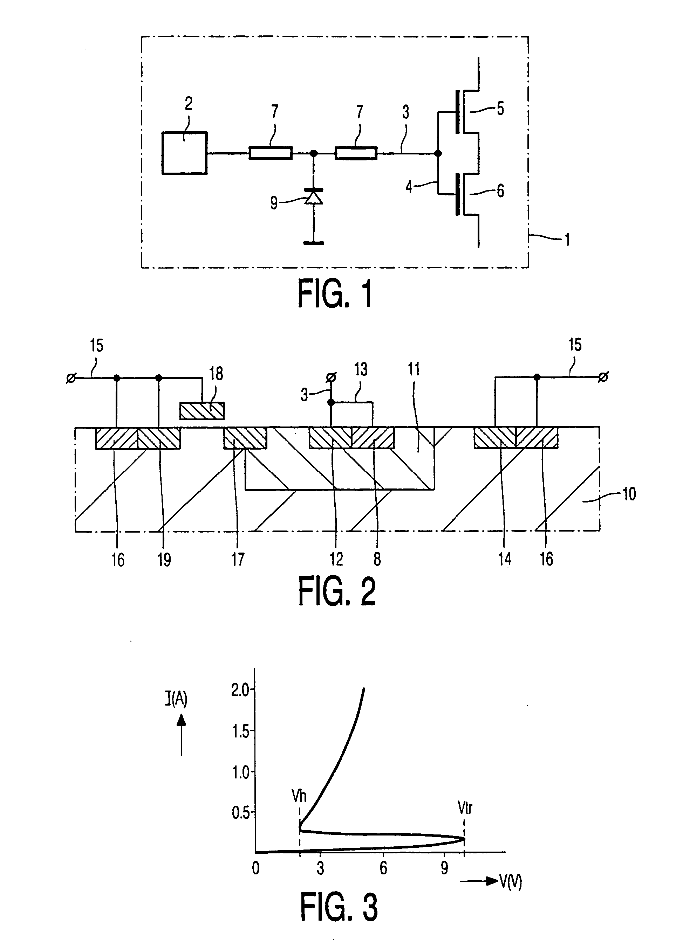

Fig. 1 shows in a diagram the input part of an integrated circuit 1 having an input path 2 which is connected by wire bonding (not shown) to an input pin of a customary envelope (not shown either). The input path 2 is connected by a conductor 3 to an input port 4 of the circuit, which input port comprises, for example, a p-channel transistor 5, and an n-channel transistor 6, the transistor gates being connected to the conductor 3. The spreading of the resistance in the conductor 3 is represented diagrammatically by the resistors 7. For protecting the circuit against damage owing to electrostatic discharge (ESD), caused, for example, by contact between the input pin of the envelope and a human body, a protection element 9 is inserted whose one side is connected to the conductor 3 and whose other side is connected to a reference voltage, for example, ground. The element 9 shown in the Figure as a diode for simplicity, is formed by a four-layer structure of alternating conductivity type, therefore, of a pnpn structure often referred to as SCR (Silicon-Controlled Rectifier). The current/voltage characteristic shows a first region (see Fig. 3) between 0 volts and Vₜᵣ volts in which the SCR element conducts no or substantially no current. This is the state in which the element is under normal conditions. In the case of the trigger voltage Vₜᵣ, the element changes to a conductive state in which the voltage drops to a low value Vₕ, the holding voltage, and the resistance of the SCR element becomes very low. For effectively protecting the circuit against ESD, it is necessary for Vₜᵣ to be lower than the voltage at which damage occurs. This means that for current CMOS processes Vₜᵣ is to be equal or substantially equal to 10 V. For a rapid discharge in the case of ESD and for keeping the heat development in the protection itself lowest possible, a lowest possible Vₕ is desired (be it higher than the supply voltage). Since the supply voltage for the ever diminishing dimensions in silicon technology shows a tendency to ever decreasing values, an SCR protection with a low Vₕ is ever more desired.

Fig. 2 shows in a cross-sectional view a protection element 9 according to the invention, which element also has a low holding voltage Vₕ when there is a suitable trigger voltage. A semiconductor body of, for example, silicon is started from, of which Fig. 2 only shows the surface area 10 containing the protection element 9. In the specific embodiment to be described here, the surface area is of the p type. However, it will be plainly evident to the expert that also embodiments which have reversed conductivity types of the various areas and zones are possible. In the surface area 10 is provided an n-type well 11, for example, during the n-well implantation for the p-channel transistors elsewhere in the semiconductor body. In the well 11 there is a p-type surface zone 8 which forms the anode of the SCR element 9 and is connected to the input path 2 via the conductor 3. By means of the contact 13 shown only diagrammatically in Fig. 2, and the highly doped contact zone 12, the anode 8 is also connected to the well 11. The p-type surface area 10 further includes an n-type surface zone 14 which lies remote from the well 11 and forms the cathode of the SCR element. By means of the conductor 15 shown diagrammatically, the cathode 14 is connected to a reference voltage, for example ground. The p-type surface area 10 is in this example also connected to ground by the conductor 15 and the highly doped p-type surface zone 16. For obtaining a sufficiently low trigger voltage, the device has a gated diode structure comprising a highly doped n-type surface zone 17 provided in the p-type surface area 10 and a gate 18 electrically insulated from the surface area 10 aligned relative to the zone 17. The zone 17 is electrically connected to the well 11 by having the zone 17 adjoin the well 11 or, as is shown in the drawing, by having it overlap the well 11. In the embodiment shown in Fig. 2 the gate 18 is connected by a conductor 15 to the substrate 10 and to the low reference voltage. In another embodiment, gate 18 is coupled to ground via a resistor and via a diode or a capacitor to zone 17. This configuration provides that the trigger voltage of the protection is not determined by the (high) breakdown voltage of the pn transition between the well 11 and the surface area 10, but by the gated diode 17, 18. The gated diode may be manufactured simultaneously with the n-channel transistors of the circuit so that, with the current standard CMOS processes, a breakdown voltage equal to or substantially equal to 10 V may be achieved.

In principle, the gated diode having the zone 17 and the gate 18 is sufficient. In the example shown, on the side of the gate 18, opposite zone 17, a further highly-doped n-type zone 19 is provided in the p-type surface area 10, so that the gated diode has the structure of a MOS transistor. The zone 19 is also connected to the low reference voltage and to the substrate 10 and, as a result, also operates as a cathode of the SCR element, be it in less efficient manner than the n-type zone 14.

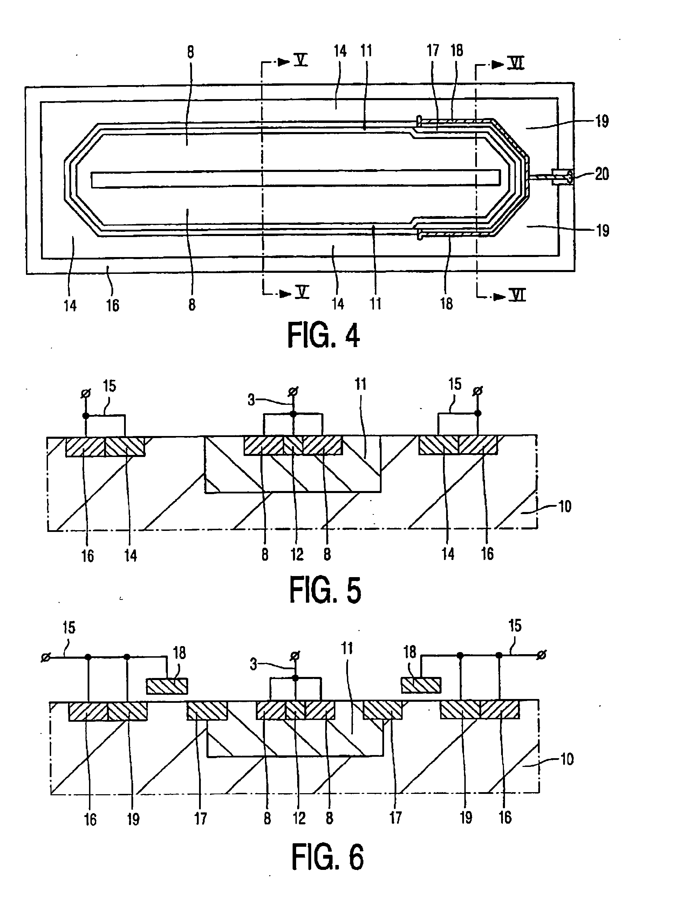

Fig. 4 shows a plan view of an ESD protection according to the invention having another layout compared with the previous example. Cross-sections of the device along the lines V-V and VI-VI are represented in Fig. 5, Fig. 6 respectively. The n-type well 11 is arranged in the form of a longitudinal zone having two ends on the left and right-hand side of the drawing. The anode 8 is formed by a longitudinal p-type zone in the n-well 11 which well has in its center an opening at the position of which a highly doped n-type zone 12 is provided which forms a contact area for the well 11. The gated diode is solely provided on the right-hand end and comprises the insulated gate 18 and the highly doped n-type zone 17 which partly overlaps the well 11. In this example, the gated diode is also arranged as a MOS transistor having a further n-type zone 19. The cathode of the SCR, formed by the highly doped n-type zone 14 is provided along the part of the periphery of the well 11 that is free from the gate 18 at a minor distance from the anode 8. The ratio between the two parts of the periphery may be chosen with relatively large freedom depending on the circumstances. Fig. 4 shows an embodiment in which the gated diode takes up only a relatively small part of the periphery of the SCR and thus has very little influence on the holding voltage Vₕ and on the current-conveying power of the SCR. At the position of the contact 20, the gate 18 is connected to the p-type substrate 10 and to the n-type cathode 14 which, together with the further zone 19, forms a coherent area. Needless to observe that, if so desired, the gate may also be connected to a junction in the circuit to another, suitable, voltage.

It will be evident that the invention is not restricted to the examples described above, but that within the framework of the invention a great many variations are possible to the expert. For example, a plurality of parallel-arranged SCR elements as shown in Fig. 4 may be used to increase the current-conveying power. In the examples described, the conductivity types may be reversed too, needless to observe that voltages to be applied are to be adapted and functions of anode and cathode are exchanged. The protection element may be used in protection circuitries, differing from the circuitry shown in Fig. 1.

## Claims

1. A semiconductor device having a semiconductor body which on a surface comprises an integrated circuit containing protection means for protection against electrostatic discharge (ESD), the means being a compound element of an SCR and a MOS transistor, the protection means being provided in a surface area (10) of a first conductivity type having a well (11) of a second, opposite, conductivity type in which area a surface zone (12) of the first conductivity type is formed forming one of the anode and cathode zones of the SCR element, and the surface area having a surface zone of the second conductivity type, further denoted as first zone (14), situated remote from the well and forming the other anode and cathode area of the SCR element, the MOS transistor containing a gate (18) insulated from the surface of the semiconductor body and a highly-doped second conductivity type surface zone (17) aligned to this gate further denoted as second zone, which aligned surface zone partly overlaps the well of the second conductivity type and which stretches out only along a part of the periphery of the well wherein the gate of the MOS transistor substantially stretches out only along that part of the periphery of the well whereas the first zone is provided along at least another part of this periphery of the well which is free from the said second zone, the MOS transistor having a further surface zone (19) of the second conductivity type, deposited in the surface area of the first conductivity type, the said second zone forming one of the source/drain zones of the transistor and the said further surface zone forming the other one of the source/drain zones of the transistor **characterized in that** the said first zone of the second conductivity type being situated at a shorter lateral distance from the surface zone of the first conductivity type provided in the well than the said further surface zone.

2. A semiconductor device as claimed in claim 1, **characterized in that** the said further zone of the second conductivity type and the said first zone of the second conductivity type form a coherent zone of the second conductivity type.

3. A semiconductor device as claimed in one of the preceding claims, **characterized in that** the first and the second conductivity type are the p-conductivity type and n-conductivity type respectively, the said first zone forming the cathode of the SCR element and the first conductivity type zone arranged in the well forming the anode of the SCR element.

## Patentansprüche

1. Halbleiteranordnung mit einem Halbleiterkörper, der auf einer Oberfläche eine integrierte Schaltung umfasst, die Schutzmittel zum Schutz gegen elektrostatische Entladung (ESD) enthält, wobei die Mittel ein Verbundelement eines SCR und eines MOS-Transistors sind, die Schutzmittel in einem Oberflächenbereich (10) eines ersten Leitfähigkeitstyps mit einer Wanne (11) eines zweiten, entgegengesetzten Leitfähigkeitstyps, in deren Fläche eine Oberflächenzone (12) des ersten Leitfähigkeitstyps gebildet ist, die eine der Anoden- und Kathodenzonen des SCR-Elements bildet, bereitgestellt sind und der Oberflächenbereich eine Oberflächenzone des zweiten Leitfähigkeitstyps, weiter als erste Zone (14) bezeichnet, hat, die sich entfernt von der Wanne befindet und die andere Anoden- und Kathodenfläche des SCR-Elements bildet, der MOS-Transistor ein von der Oberfläche des Halbleiterkörpers isoliertes Gate (18) und eine zu diesem Gate ausgerichtete, hoch dotierte Oberflächenzone (17) des zweiten Leitfähigkeitstyps, weiter als zweite Zone bezeichnet, enthält, wobei die ausgerichtete Oberflächenzone teilweise die Wanne des zweiten Leitfähigkeitstyps überlappt und sich nur entlang eines Teils der Peripherie der Wanne erstreckt, in der sich das Gate des Transistors im Wesentlichen nur entlang des Teils der Peripherie der Wanne erstreckt, während die erste Zone entlang mindestens eines anderen Teils dieser Peripherie der Wanne, das frei von der genannten zweiten Zone ist, bereitgestellt ist, wobei der MOS-Transistor eine weitere, in dem Oberflächenbereich des ersten Leitfähigkeitstyps deponierte Oberflächenzone (19) des zweiten Leitfähigkeitstyps hat, die genannte zweite Zone eine der Source/Drain-Zonen des Transistors bildet und die genannte weitere Oberflächenzone die andere der Source/Drain-Zonen des Transistors bildet, **dadurch gekennzeichnet, dass** die genannte erste Zone des zweiten Leitfähigkeitstyps in einem kürzeren lateralen Abstand zu der in der Wanne bereitgestellten Oberflächenzone des ersten Leitfähigkeitstyps angeordnet ist als die genannte weitere Oberflächenzone.

2. Halbleiteranordnung nach Anspruch 1, **dadurch gekennzeichnet, dass** die genannte weitere Zone des zweiten Leitfähigkeitstyps und die genannte erste Zone des zweiten Leitfähigkeitstyps eine zusammenhängende Zone des zweiten Leitfähigkeitstyps bilden.

3. Halbleiteranordnung nach einem der vorhergehenden Ansprüche, **dadurch gekennzeichnet, dass** der erste und der zweite Leitfähigkeitstyp der p-Leitfähigkeitstyp beziehungsweise n-Leitfähigkeitstyp sind, die genannte erste Zone die Kathode des SCR-Elements bildet und die in der Wanne angeordnete Zone des ersten Leitfähigkeitstyps die Anode des SCR-Elements bildet.

## Revendications

1. Dispositif à semi-conducteur comportant un corps semi-conducteur qui, sur une surface, comprend un circuit intégré contenant des moyens de protection pour protéger des décharges électrostatiques, les moyens étant un élément composé d'un SCR et d'un transistor MOS, les moyens de protection étant montés dans une région de surface (10) d'un premier type de conductivité comportant un caisson (11) d'un deuxième type de conductivité, opposé, région dans laquelle une zone de surface (12) du premier type de conductivité est formée, formant une des zones d'anode et de cathode de l'élément SCR, et la région de surface comportant une zone de surface du deuxième type de conductivité, également appelée première zone (14), située à distance du caisson et formant l'autre zone d'anode et de cathode de l'élément SCR, le transistor MOS contenant une grille (18) isolée de la surface du corps semi-conducteur et une zone de surface du deuxième type de conductivité fortement dopée (17) alignée sur cette grille, également appelée deuxième zone, laquelle zone de surface alignée chevauche partiellement le caisson du deuxième type de conductivité et qui s'étend uniquement le long d'une partie de la périphérie du caisson dans laquelle la grille du transistor MOS s'étend sensiblement uniquement le long de cette partie de la périphérie du caisson tandis que la première zone est formée le long d'au moins une autre partie de la périphérie du caisson qui est libre de ladite deuxième zone, le transistor MOS comportant une autre zone de surface (19) du deuxième type de conductivité, déposée dans la région de surface du premier type de conductivité, ladite deuxième zone formant une des zones de source/drain du transistor et ladite autre zone de surface formant l'autre des zones de source/drain du transistor, **caractérisé en ce que** ladite première zone du deuxième type de conductivité est située à une distance latérale plus courte de la zone de surface du premier type de conductivité déposée dans le caisson que ladite autre zone de surface.

2. Dispositif à semi-conducteur suivant la revendication 1, **caractérisé en ce que** ladite autre zone du deuxième type de conductivité et ladite première zone du deuxième type de conductivité forment une zone cohérente du deuxième type de conductivité.

3. Dispositif à semi-conducteur suivant l'une quelconque des revendications précédentes, **caractérisé en ce que** le premier et le deuxième types de conductivité sont le type de conductivité P et le type de conductivité N, respectivement, ladite première zone formant la cathode de l'élément SCR et la zone du premier type de conductivité disposée dans le caisson formant l'anode de l'élément SCR.
